# EUROPEAN PATENT APPLICATION

(11) **EP 4 432 807 A1**
(43) Date of publication of application: **18.09.2024**
(21) Application number: 24157124.9
(22) Date of filing: 12.02.2024
(51) Int. Cl.: H10B 43/27, H10B 41/27

(54) **INTEGRATED CIRCUIT DEVICE AND ELECTRONIC SYSTEM HAVING THE SAME**

(30) Priority: 21.02.2023 KR 20230023157
(71) Applicant: Samsung Electronics Co., Ltd., Suwon-si, Gyeonggi-do 16677 (KR)
(72) Inventor: PARK, Kyeonghoon, 16677 Suwon-si (KR); KIM, Hyunho, 16677 Suwon-si (KR); BAEK, Jaebok, 16677 Suwon-si (KR); YUN, Janggn, 16677 Suwon-si (KR); HAN, Jeehoon, 16677 Suwon-si (KR)
(74) Representative: Marks & Clerk LLP

(57) **Abstract**

Provided is an integrated circuit device with increased electrical reliability by forming an ohmic junction between a contact structure and a wiring line by bypassing a common source line such that the common source line, to which a common source line driver is connected, is electrically connected to the contact structure through the wiring line.

## Description

### BACKGROUND

The inventive concepts relate to integrated circuit devices and/or electronic systems having the same, and more particularly, to vertical nonvolatile memory devices and/or electronic systems having the same.

In order to meet excellent performance and economic feasibility, increasing the degree of integration of integrated circuit devices is needed. In particular, the degree of integration of memory devices is an important factor in determining the economic feasibility of a product. Because the degree of integration of two-dimensional memory devices is mainly determined by the area occupied by unit memory cells, the level of fine pattern formation technology greatly affects the degree of integration of two-dimensional memory devices. However, because expensive equipment is required to form a fine pattern and the area of a chip die is limited, there is still a limit to increasing the degree of integration of two-dimensional memory devices. Accordingly, a vertical memory device having a three-dimensional structure is required.

### SUMMARY

Some example embodiments of the inventive concepts provide integrated circuit devices with increased electrical reliability by forming an ohmic junction between a contact structure and a wiring line by bypassing a common source line such that the common source line, to which to a common source line driver is connected, is electrically connected to the contact structure through the wiring line.

Tasks to be solved by the inventive concepts are not limited to the above-mentioned task, and other tasks not mentioned may be clearly understood by those of ordinary skill in the art from the following description.

According to an example embodiment of the inventive concepts, an integrated circuit device includes a peripheral circuit structure and a cell array structure, wherein the peripheral circuit structure includes a circuit board, a peripheral circuit on the circuit board, a first insulating layer covering the circuit board and the peripheral circuit, and first bonding pads on the first insulating layer and electrically connected to the peripheral circuit, and wherein the cell array structure includes an insulating structure having a first surface and a second surface, the first surface facing the circuit board, the second surface being opposite to the first surface, a plurality of gate electrode layers spaced apart from each other in a vertical direction on the first surface of the insulating structure, and stacked in a step form, a plurality of channel structures passing through the plurality of gate electrode layers, a cell contact plug passing through at least a portion of the plurality of gate electrode layers, a first contact structure and a second contact structure laterally spaced apart from the plurality of gate electrode layers, a common source line structure conformally surrounding an upper portion of the plurality of channel structures and being inside the insulating structure, a first wiring line and a second wiring line spaced apart from each other on the second surface of the insulating structure, first conductive vias passing through the insulating structure, connecting the common source line structure with the first wiring line, and connecting the first contact structure with the first wiring line, a second conductive via passing through the insulating structure and connecting the second contact structure with the second wiring line, and second bonding pads connected to a lower portion of the plurality of channel structures, a lower portion of the cell contact plug, a lower portion of the first contact structure, and a lower portion of the second contact structure, and bonded to the first bonding pads. An ohmic junction may be formed between the first contact structure and the first wiring line. The ohmic junction may bypass the common source line structure.

According to an example embodiments of the inventive concepts, an integrated circuit device includes an insulating structure having a memory cell region, a connection region surrounding the memory cell region, and an outer pad region surrounding the connection region, a gate stack including a plurality of gate electrode layers and a plurality of mold insulating layers, the plurality of gate electrode layers and the plurality of mold insulating layers extending in a horizontal direction and alternately stacked in a vertical direction on a bottom surface of the insulating structure, and the gate stack having a staircase structure in the connection region, a plurality of channel structures passing through the gate stack in the vertical direction and extending to an inside of the insulating structure in the memory cell region, a word line cut passing through the gate stack in the vertical direction in the memory cell region and the connection region, the word line cut extending to the inside of the insulating structure, a first contact structure and a second contact structure laterally spaced apart from the gate stack in the outer pad region, the first contact structure and the second contact structure extending to the inside of the insulating structure, a common source line structure conformally surrounding an upper portion of the plurality of channel structures and an upper portion of the word line cut, an upper portion of the plurality of channel structures and an upper portion of the word line cut being inside the insulating structure, a first wiring line extending along the memory cell region, the connection region, and the outer pad region on a top surface of the insulating structure, a second wiring line in the outer pad region and spaced apart from the first wiring line, first conductive vias passing through the insulating structure, connecting the common source line structure with the first wiring line, in the memory cell region, and connecting the first contact structure with the first wiring line in the outer pad region, and a second conductive via passing through the insulating structure and connecting the second contact structure with the second wiring line, in the outer pad region. The bottom surface may correspond to a first surface of the insulating structure. The top surface may correspond to a second surface of the insulating structure. The terms top and bottom may be reversed. An ohmic junction may be formed between the first contact structure and the first wiring line. The ohmic junction may bypass the common source line structure.

According to an example embodiments of the inventive concepts, an electronic system includes a main substrate, an integrated circuit device on the main substrate, and a controller electrically connected to the integrated circuit device on the main substrate, wherein the integrated circuit device includes a peripheral circuit structure including a circuit board, a peripheral circuit on the circuit board, a first insulating layer covering the circuit board and the peripheral circuit, and first bonding pads on the first insulating layer and electrically connected to the peripheral circuit, and the cell array structure stacked on the peripheral circuit structure, the cell array structure including an insulating structure with a first surface facing the circuit board and a second surface being opposite to the first surface, a plurality of gate electrode layers spaced apart from each other in a vertical direction on the first surface of the insulating structure, and stacked in a step form, a plurality of channel structures passing through the plurality of gate electrode layers, a cell contact plug passing through at least a portion of the plurality of gate electrode layers, a first contact structure and a second contact structure laterally spaced apart from the plurality of gate electrode layers, a common source line structure conformally surrounding an upper portion of the plurality of channel structures that is inside the insulating structure, a first wiring line and a second wiring line spaced apart from each other on the second surface of the insulating structure, first conductive vias passing through the insulating structure, connecting the common source line structure with the first wiring line, and connecting the first contact structure with the first wiring line, a second conductive via passing through the insulating structure and connecting the second contact structure with the second wiring line, and second bonding pads connected to a lower portion of the plurality of channel structures, a lower portion of the cell contact plug, a lower portion of the first contact structure, and a lower portion of the second contact structure, and bonded to the first bonding pads. An ohmic junction may be formed between the first contact structure and the first wiring line. The ohmic junction may bypass the common source line structure.

At least some of the above and other features of the disclosure are set out in the claims.

### BRIEF DESCRIPTION OF THE DRAWINGS

Example embodiments of the inventive concepts will be more clearly understood from the following detailed description taken in conjunction with the accompanying drawings in which:
FIG. 1 is a block diagram illustrating an integrated circuit device according to an example embodiment;
FIG. 2 is a perspective view schematically illustrating an integrated circuit device according to an example embodiment;
FIG. 3 is an equivalent circuit diagram illustrating a memory cell array of an integrated circuit device according to an example embodiment;
FIG. 4 is a cross-sectional view illustrating components of an integrated circuit device according to an example embodiment;
FIG. 5 is an enlarged view illustrating both portions AA and BB of FIG. 4;
FIG. 6 is an enlarged view illustrating portion CC of FIG. 5;
FIG. 7 is an enlarged view illustrating portion DD of FIG. 5;
FIG. 8 is a plan view illustrating portions corresponding to FIG. 5;
FIGS. 9 and 10 are plan views illustrating an integrated circuit device according to some example embodiments;
FIG. 11 is a flowchart illustrating a method of manufacturing an integrated circuit device, according to an example embodiment;
FIGS. 12 to 19 are cross-sectional views showing, in accordance with a process sequence, a method of manufacturing an integrated circuit device, according to an example embodiment;
FIG. 20 is a diagram illustrating an electronic system including an integrated circuit device, according to an example embodiment;
FIG. 21 is a perspective diagram illustrating an electronic system including an integrated circuit device, according to an example embodiment; and
FIG. 22 is a cross-sectional view illustrating a semiconductor package including an integrated circuit device, according to an example embodiment.

### DETAILED DESCRIPTION

Hereinafter, some example embodiments of the inventive concepts will be described in detail with reference to the accompanying drawings.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the terms "about" or "substantially" are used in this specification in connection with a numerical value, it is intended that the associated numerical value includes a manufacturing or operational tolerance (e.g., ±10%) around the stated numerical value. Moreover, when the words "about" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance range (e.g., ±10%) around the stated numerical values or shapes.

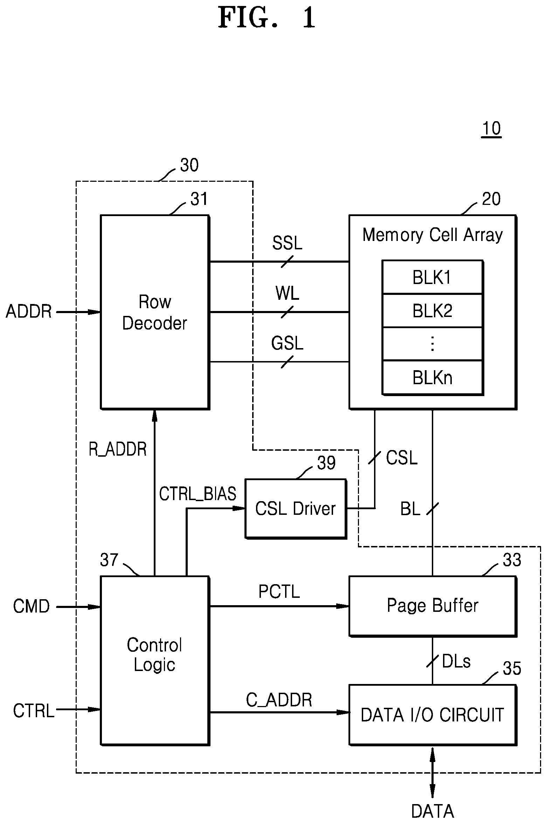

FIG. 1 is a block diagram illustrating an integrated circuit device according to an example embodiment.

Referring to FIG. 1, the integrated circuit device 10 may include a memory cell array 20 and a peripheral circuit 30.

The memory cell array 20 may include a plurality of memory cell blocks BLK1, BLK2, ..., and BLKn. Each of the plurality of memory cell blocks BLK1, BLK2, ..., and BLKn may include a plurality of memory cells. The plurality of memory cell blocks BLK1, BLK2, ..., and BLKn may be connected to the peripheral circuit 30 through a bit line BL, a word line WL, a string selection line SSL, a common source line CSL, and a ground selection line GSL.

The memory cell array 20 may be connected to a page buffer 33 through the bit line BL, and may be connected to a row decoder 31 through the word line WL, the string selection line SSL, and the ground selection line GSL. In the memory cell array 20, each of the plurality of memory cells included in the plurality of memory cell blocks BLK1, BLK2, ..., and BLKn may be a flash memory cell. The memory cell array 20 may include a three-dimensional memory cell array. The three-dimensional memory cell array may include a plurality of NAND strings, and each of the plurality of NAND strings may include a plurality of memory cells connected to a plurality of word lines WL stacked vertically.

The peripheral circuit 30 may include the row decoder 31, the page buffer 33, a data input/output (I/O) circuit 35, a control logic 37, and a common source line driver 39. Although not illustrated, the peripheral circuit 30 may further include various circuits such as a voltage generation circuit that generates various voltages necessary for the operation of the integrated circuit device 10, an error correction circuit for correcting errors in data read from the memory cell array 20, an input/output interface, and the like.

The peripheral circuit 30 may receive an address ADDR, a command CMD, and a control signal CTRL from the outside of the integrated circuit device 10, and may transmit and receive data to and from an external device which is located outside the integrated circuit device 10.

The configuration of the peripheral circuit 30 will be described below in detail.

The row decoder 31 may select at least one of the plurality of memory cell blocks BLK1, BLK2, ..., and BLKn in response to the address ADDR from the outside, and may select the word line WL, the string selection line SSL, and the ground selection line GSL of the selected memory cell block. The row decoder 31 may transmit a voltage for performing a memory operation to the word line WL of the selected memory cell block.

The page buffer 33 may be connected to the memory cell array 20 through the bit line BL. The page buffer 33 may operate as a write driver during a program operation to apply a voltage according to the data to be stored in the memory cell array 20 to the bit line BL, and may operate as a sensing amplifier to detect the data stored in the memory cell array 20 during a read operation. The page buffer 33 may operate according to the control signal PCTL provided from the control logic 37.

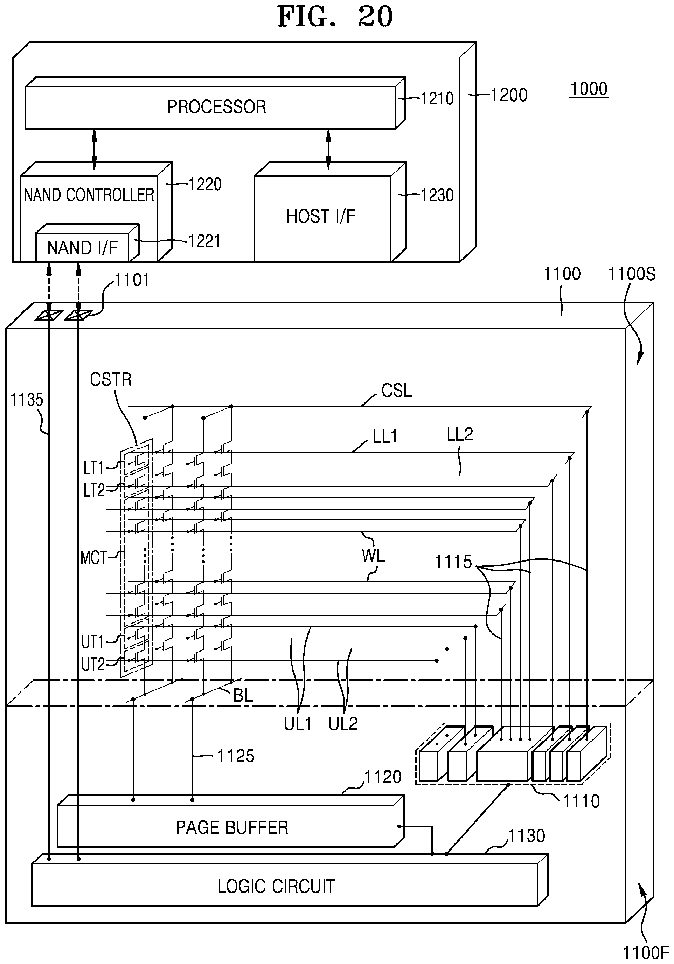

The data I/O circuit 35 may be connected to the page buffer 33 through data lines DLs. The data I/O circuit 35 may receive data from a controller 1200 of FIG. 20 during the program operation, and provide program data to the page buffer 33 based on a column address C_ADDR provided from the control logic 37. The data I/O circuit 35 may provide read data stored in the page buffer 33 to the controller 1200 (see FIG. 20) based on the column address C_ADDR provided from the control logic 37 during the read operation. The data I/O circuit 35 may transmit an input address or command to the control logic 37 or the row decoder 31.

The control logic 37 may receive a command CMD and a control signal CTRL from the controller 1200 (see FIG. 20). The control logic 37 may provide a row address R_ADDR to the row decoder 31 and provide the column address C_ADDR to the data I/O circuit 35. The control logic 37 may generate various internal control signals used in the integrated circuit device 10 in response to the control signal CTRL. For example, the control logic 37 may adjust the voltage level provided to the word line WL and the bit line BL when performing memory operations such as the program operation or an erase operation.

The common source line driver 39 may be connected to the memory cell array 20 through the common source line CSL. The common source line driver 39 may apply a common source voltage (e.g., a power supply voltage) or a ground voltage to the memory cell array 20 through the common source line CSL under the control of the control logic 37.

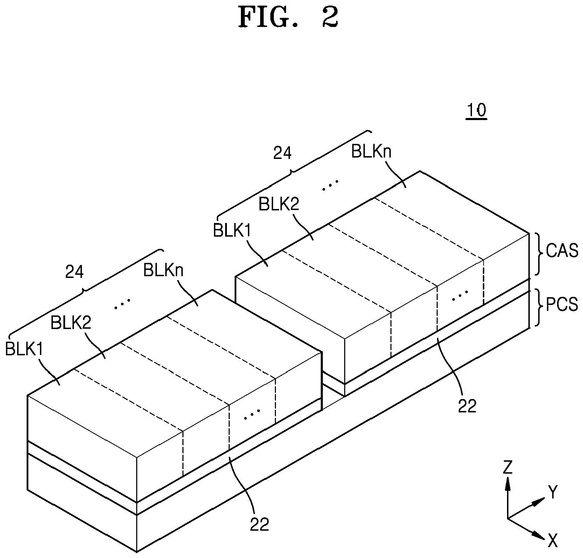

FIG. 2 is a perspective view schematically illustrating an integrated circuit device according to an example embodiment.

Referring to FIG. 2, the integrated circuit device 10 includes a peripheral circuit structure PCS and a cell array structure CAS overlapping each other in the vertical direction (Z direction). While the cell array structure CAS is illustrated as being above the peripheral circuit structure PCS in the vertical direction (Z direction) in FIG. 2, this configuration may be reversed, i.e., the peripheral circuit structure PCS may be above the cell array structure CAS in the vertical direction (Z direction).

The cell array structure CAS may include the memory cell array 20 (see FIG. 1) and the peripheral circuit structure PCS may include the peripheral circuit 30 (see FIG. 1).

A connection structure 22 may be provided between the cell array structure CAS and the peripheral circuit structure PCS. The cell array structure CAS and the peripheral circuit structure PCS may be stacked in a vertical direction (Z direction) through the connection structure 22. The connection structure 22 may provide a physical connection and an electrical connection between the cell array structure CAS and the peripheral circuit structure PCS. Electrical connection and data transfer between the cell array structure CAS and the peripheral circuit structure PCS may be performed through the connection structure 22.

The connection structure 22 may include a plurality of connection portions for electrically connecting the cell array structure CAS with the peripheral circuit structure PCS. The plurality of connection portions may include a metal-metal bonding structure, a through silicon via (TSV), a back via stack (BVS), a eutectic bonding structure, a ball grid array (BGA) bonding structure, a plurality of wiring lines, a plurality of contact plugs, or a combination thereof. For example, the metal-metal bonding structure may include copper (Cu), aluminum (Al), tungsten (W), or a combination thereof.

The cell array structure CAS may include a plurality of tiles 24. Each of the plurality of tiles 24 may include a plurality of memory cell blocks BLK1, BLK2, ..., and BLKn. Each of the plurality of memory cell blocks BLK1, BLK2, ..., and BLKn may include memory cells which are arranged three-dimensionally.

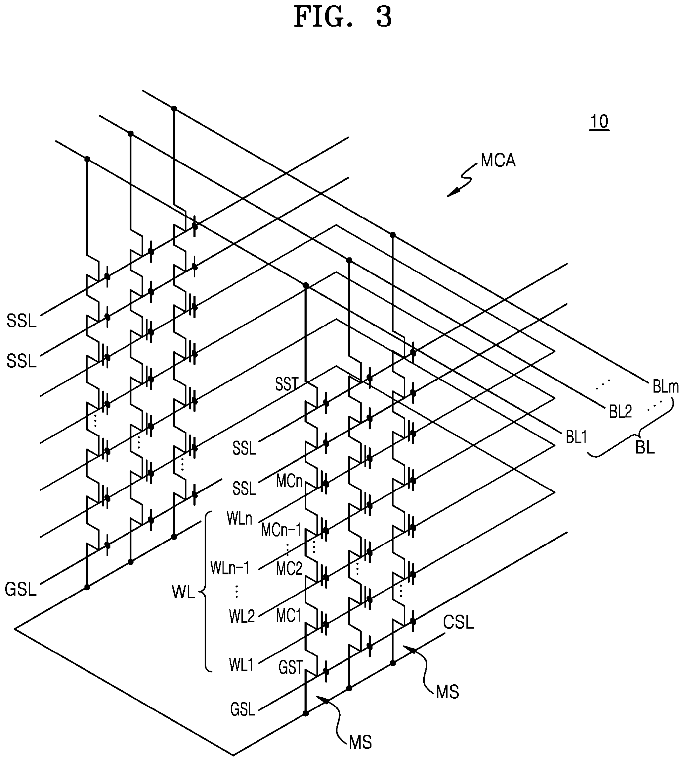

FIG. 3 is an equivalent circuit diagram illustrating a memory cell array of an integrated circuit device according to an example embodiment.

Referring to FIG. 3, an equivalent circuit diagram of a vertical NAND flash memory device having a vertical channel structure is illustrated.

In the integrated circuit device 10 according to an example embodiment, the memory cell array MCA may include a plurality of memory cell strings MS. The memory cell array MCA may include a plurality of bit lines BL, a plurality of word lines WL, at least one string selection line SSL, at least one ground selection line GSL, and a common source line CSL.

The plurality of memory cell strings MS may be formed between the plurality of bit lines BL and the common source line CSL. In FIG. 3, a case in which each of the plurality of memory cell strings MS includes two string selection lines SSL is illustrated, but the inventive concepts are not limited thereto. For example, each of a plurality of memory cell strings MS may include one string selection line SSL.

Each of the plurality of memory cell strings MS may include a string selection transistor SST, a ground selection transistor GST, and a plurality of memory cell transistors MC1, MC2, ..., MCn-1, and MCn. The drain region of the string selection transistor SST may be connected to the bit line BL, and the source region of the ground selection transistor GST may be connected to the common source line CSL. The common source line CSL may be a region in which source regions of the plurality of ground selection transistors GST are commonly connected.

The string selection transistor SST may be connected to the string selection line SSL, and the ground selection transistor GST may be connected to the ground selection line GSL. The plurality of memory cell transistors MC1, MC2, ..., MCn-1, and MCn may be connected in correspondence to a plurality of word lines WL1, WL2, ..., WLn-1, and WLn, respectively.

Each of the plurality of memory cell blocks BLK1, BLK2, ..., and BLKn described above with reference to FIGS. 1 and 2 may include the memory cell array MCA having the circuit configuration described in FIG. 3.

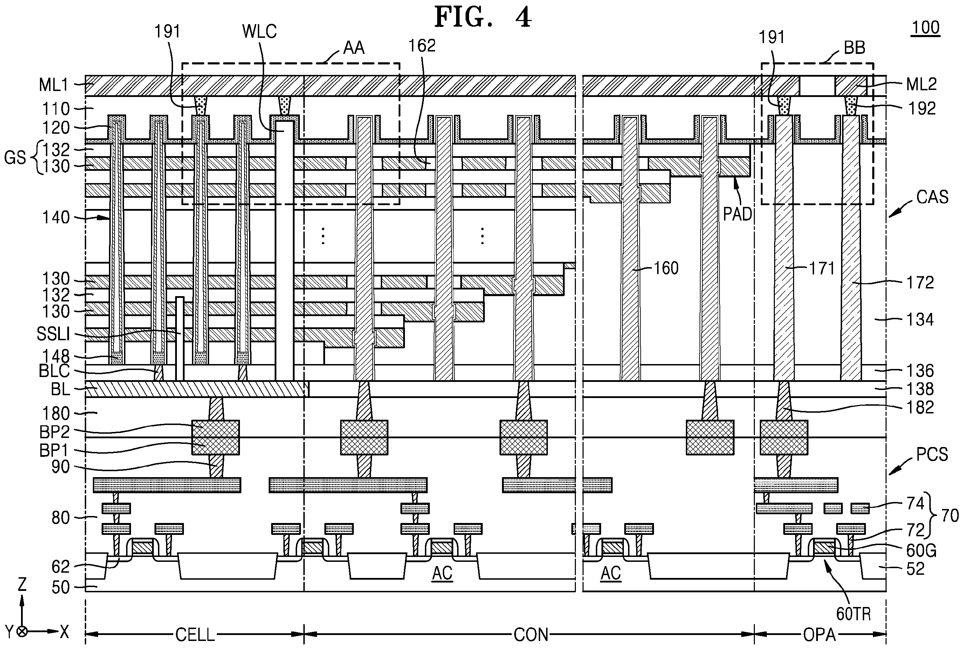

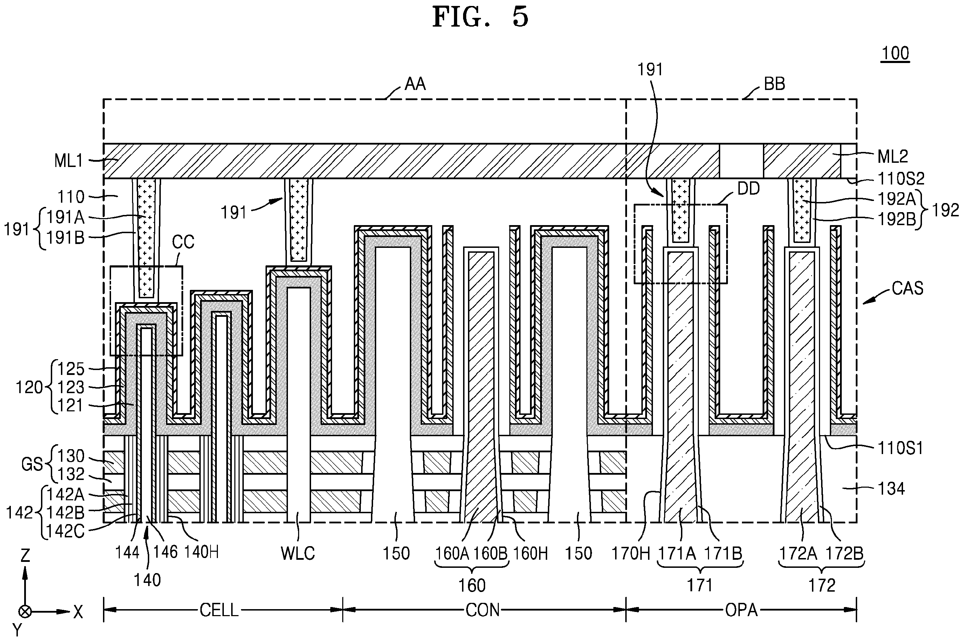

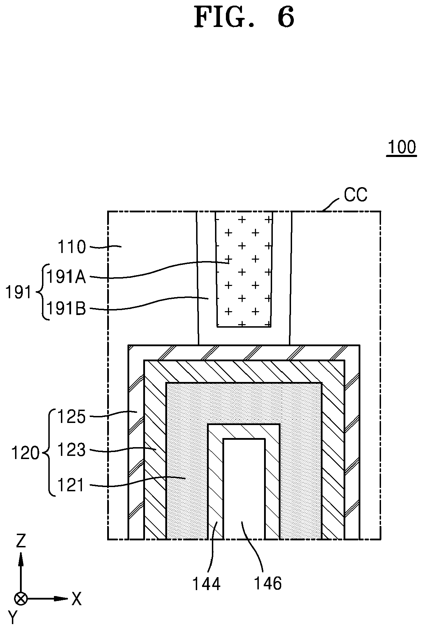

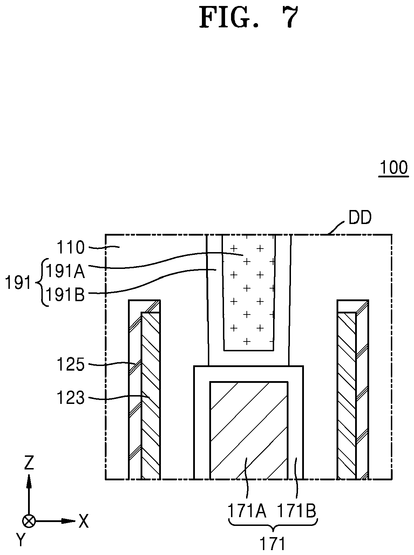

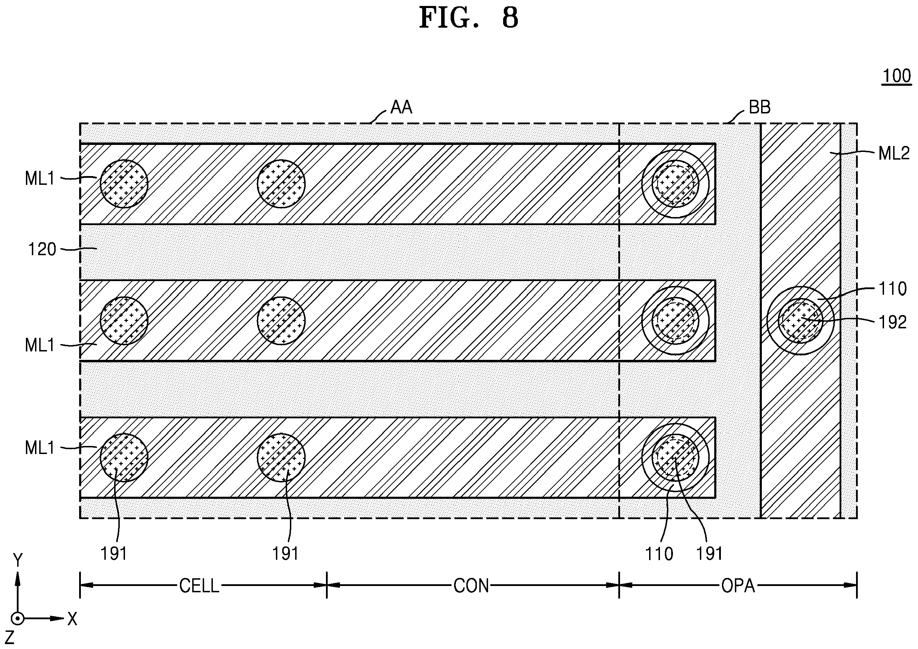

FIG. 4 is a cross-sectional view illustrating components of an integrated circuit device according to an example embodiment. For example, FIG. 5 is an enlarged view illustrating both portions AA and BB of FIG. 4. FIG. 6 is an enlarged view illustrating portion CC of FIG. 5, FIG. 7 is an enlarged view illustrating a portion DD of FIG. 5, and FIG. 8 is a plan view illustrating portions corresponding to FIG. 5.

Referring to FIGS. 4 to 8, an integrated circuit device 100 according to as example embodiment may include a peripheral circuit structure PCS and a cell array structure CAS on the peripheral circuit structure PCS.

The cell array structure CAS may be stacked on the peripheral circuit structure PCS so that a plurality of first bonding pads BP1 of the peripheral circuit structure PCS and a plurality of second bonding pads BP2 of the cell array structure CAS are bonded to each other. In some example embodiments, when both the first bonding pad BP1 and the second bonding pad BP2 include copper (Cu), the peripheral circuit structure PCS may be bonded to the cell array structure CAS by copper (Cu)-copper (Cu) bonding.

The peripheral circuit structure PCS may be referred to as a first structure, and may include the peripheral circuit 30 described with reference to FIG. 1. In addition, the cell array structure CAS may be referred to as a second structure and may include the memory cell array 20 described with reference to FIG. 1.

The peripheral circuit structure PCS may include a peripheral circuit transistor 60TR arranged on a circuit board 50 and a peripheral circuit wiring 70 connected thereto. The circuit board 50 may include a cell region CELL, a connection region CON, and an outer pad region OPA, which are horizontally arranged (the X direction). In other words, the connection region CON may be placed to surround the cell region CELL, and the outer pad region OPA may be placed to surround the connection region CON.

Active regions AC may be defined by device isolation layers 52 on the circuit board 50, and the plurality of peripheral circuit transistors 60TR may be formed on the active region AC. Each of the plurality of peripheral circuit transistors 60TR may include a peripheral circuit gate 60G and a source/drain region 62 arranged on a portion of the circuit board 50 on both sides of the peripheral circuit gate 60G.

The circuit board 50 may include a group IV semiconductor, a group III-V compound semiconductor, or a group II-VI oxide semiconductor, which is a semiconductor material. For example, the Group IV semiconductor may include silicon (Si), germanium (Ge), or silicon-germanium (SiGe). In some example embodiments, the circuit board 50 may be provided as a bulk wafer or an epitaxial wafer. In other example embodiments, the circuit board 50 may include a silicon-on-insulator (SOI) substrate or a germanium-on-insulator (GeOI) substrate.

The peripheral circuit wiring 70 includes a plurality of peripheral circuit contacts 72 and a plurality of peripheral circuit metal layers 74. A first insulating layer 80 covering the peripheral circuit transistor 60TR and the peripheral circuit wiring 70 may be arranged on the circuit board 50. The plurality of peripheral circuit metal layers 74 may have a multilayer structure arranged at different vertical levels.

The first bonding pad BP1 may be arranged on the first insulating layer 80. In some example embodiments, the top surface of the first bonding pad BP1 may be a coplanar with the top surface of the first insulating layer 80. That is, the first bonding pad BP1 may not protrude from the top surface of the first insulating layer 80. The first bonding pad BP1 may be made of a conductive material including copper (Cu), gold (Au), silver (Ag), aluminum (Al), tungsten (W), titanium (Ti), tantalum (Ta), or a combination thereof.

The cell array structure CAS may alternately include a plurality of gate electrode layers 130 and a plurality of mold insulation layers 132 downwardly in the vertical direction (Z direction) on the first surface 110S1 of the insulating structure 110. The plurality of gate electrode layers 130 and the plurality of mold insulating layers 132 may be referred to as a gate stack GS.

Although not illustrated, the gate electrode layer 130 may include a buried conductive layer and a conductive barrier layer surrounding the upper, lower, and side surfaces of the buried conductive layer. For example, the buried conductive layer may be made of metal, metal silicide, doped polysilicon, or a combination thereof. In addition, the conductive barrier layer may be formed of titanium nitride, tantalum nitride, tungsten nitride, or a combination thereof.

In some example embodiments, the plurality of gate electrode layers 130 may correspond to a ground selection line GSL, a word line WL, and at least one string selection line SSL constituting the memory cell string MS (see FIG. 2). For example, in the drawing, one gate electrode layer 130 on the uppermost portion may function as the ground selection line GSL, two gate electrode layers 130 on the lowermost portion may function as the string selection line SSL, and the remaining gate electrode layers 130 may function as the word line WL. Accordingly, the ground selection transistor GST and the string selection transistor SST and the memory cell string MS in which the memory cell transistors MC1, MC2, ..., MCn-1 and MCn are connected in series between the ground selection transistor GST and the string selection transistor SST may be provided.

In the cell region CELL, a plurality of channel structures 140 may penetrate the gate stack GS and extend in a vertical direction (Z direction). The plurality of channel structures 140 may be arranged at desired (or alternatively, predetermined) intervals in the first horizontal direction (X direction) and the second horizontal direction (Y direction). The plurality of channel structures 140 may be arranged in a zigzag shape or a staggered shape.

Each of the plurality of channel structures 140 may be arranged in a channel hole 140H. Each of the plurality of channel structures 140 may include a gate insulating layer 142, a channel layer 144, a buried insulating layer 146, and a conductive plug 148. The gate insulating layer 142 and the channel layer 144 may be sequentially arranged on the sidewall of the channel hole 140H. For example, the gate insulation layer 142 may be conformally placed on the sidewall of the channel hole 140H, and the channel layer 144 may be conformally placed on the inner wall of the channel hole 140H. The buried insulating layer 146 filling the residual space of the channel hole 140H may be arranged on the channel layer 144. In the drawing, a conductive plug 148 that contacts the channel layer 144 and blocks the entrance of the channel hole 140H may be arranged under the channel hole 140H. In the drawing, an upper portion of the channel layer 144 and an upper portion of the buried insulating layer 146 may extend to the inside of the insulating structure 110, on the upper side of the channel hole 140H.

The gate insulation layer 142 may have a structure sequentially including a tunneling dielectric layer 142A, a charge storage layer 142B, and a blocking dielectric layer 142C on the outer wall of the channel layer 144. The tunneling dielectric layer 142A may include silicon oxide, hafnium oxide, aluminum oxide, zirconium oxide, tantalum oxide, etc. The charge storage layer 142B is a region where electrons passing through the tunneling dielectric layer 142A from the channel layer 144 may be stored and may include silicon nitride, boron nitride, silicon boron nitride, or impurity-doped polysilicon. The blocking dielectric layer 142C may be formed of silicon oxide, silicon nitride, or a metal oxide having a higher dielectric constant than silicon oxide.

In the drawing, the two gate electrode layers 130 on the lowermost portion may be separated into two portions in a plane by a string separation insulating layer SSLI. The two portions may be spaced apart from each other in the first horizontal direction (X direction) with the string separation insulating layer SSLI therebetween. The two portions may constitute a string selection line SSL described with reference to FIG. 1.

In the cell region CELL and/or the connection region CON, a word line cut WLC penetrating the gate stack GS may be arranged. The word line cut WLC may be formed of silicon oxide, silicon nitride, SiON, SiOCN, SiCN, or a combination thereof.

In the connection region CON, a portion of the gate electrode layer 130 may constitute a pad structure PAD. The plurality of gate electrode layers 130 may have a shorter length in the first horizontal direction (X direction) as they move away from the first surface 110S1 of the insulating structure 110 in the vertical direction (Z direction). That is, the pad structure PAD may refer to a portion of the gate electrode layer 130 arranged in a stepped form.

A cover insulating layer 134 may be arranged on the pad structure PAD, and a contact insulating layer 136 may be arranged on a mold insulating layer 132 and the cover insulating layer 134 at the bottom of Fig. 4.

In the cell region CELL, a bit line contact BLC may penetrate a contact insulation layer 136 to contact a conductive plug 148 of a channel structure 140, and a bit line BL may be placed on the bit line contact BLC. A line insulating layer 138 covering a sidewall of the bit line BL may be arranged on the contact insulating layer 136.

In the connection region CON, a cell contact plug 160 may be arranged inside a cell contact hole 160H penetrating the contact insulation layer 136, the cover insulation layer 134, the plurality of gate electrode layers 130, and the plurality of mold insulation layers 132.

The cell contact plug 160 may include a buried conductive layer 160A that penetrates the plurality of gate electrode layers 130 and extends in a vertical direction (Z direction), and a conductive barrier layer 160B surrounding the side and top surfaces of the buried conductive layer 160A. For example, the buried conductive layer 160A may be formed of metal, metal silicide, doped polysilicon, or a combination thereof. In addition, the conductive barrier layer 160B may be formed of titanium nitride, tantalum nitride, tungsten nitride, or a combination thereof.

The cell contact plug 160 may be electrically connected to the pad structure PAD corresponding thereto. The cell contact plug 160 includes a vertical portion extending in a vertical direction (Z direction) and a protrusion portion protruding in a horizontal direction (X or Y direction) from the vertical portion, and the protrusion portion may contact the sidewall of the pad structure PAD to be electrically connected thereto.

A portion of the cell contact plug 160 may be surrounded by the plurality of mold insulating layers 132 and a plurality of insulating ring patterns 162. The plurality of insulating ring patterns 162 may be arranged between a portion of the cell contact plug 160 and a plurality of gate electrode layers 130.

In the drawings, the upper portion of the cell contact plug 160 may be arranged to extend to the inside of the insulating structure 110. The lowermost portion of the cell contact plug 160 may be in contact with a second bonding via 182, and the second bonding via 182 may be covered by an interlayer insulating layer 180. The second bonding via 182 may be in contact with a top surface of the second bonding pad BP2.

The cell contact plug 160 is connected to the peripheral circuit structure PCS through the second bonding via 182 and the second bonding pad BP2. In addition, through a first bonding via 90 and the first bonding pad BP1 of the peripheral circuit structure PCS, the cell contact plug 160 may be electrically connected to the peripheral circuit transistor 60TR.

In addition, a dummy contact plug 150 may be arranged around the cell contact plug 160. In some example embodiments, the dummy contact plug 150 may be made of an insulating material. In the drawings, the upper portion of the dummy contact plug 150 may be arranged to extend to the inside of the insulating structure 110.

In the outer pad region OPA, a contact insulating layer 136, a cover insulating layer 134, and a through hole 170H may be arranged, and a first contact structure 171 and a second contact structure 172 may be arranged in the through hole 170H. The first contact structure 171 may electrically connect a common source line structure 120 with the common source line driver 39 (see FIG. 1). The second contact structure 172 may function as an input/output connection wiring 1135 (see FIG. 20) that is electrically connected to an input/output pad 1101 (see FIG. 20).

The first contact structure 171 and the second contact structure 172 may include, for example, tungsten (W), titanium (Ti), tantalum (Ta), copper (Cu), aluminum (Al), titanium nitride, tantalum nitride, tungsten nitride, or a combination thereof. In the drawings, the upper portion of each of the first contact structure 171 and the second contact structure 172 may be arranged to extend to the inside of the insulating structure 110. Further, the first contact structure 171 and the second contact structure 172 may be laterally spaced apart from the plurality of gate electrode layers 130.

In the integrated circuit device 100 of the present example embodiment, the common source line structure 120 may be arranged inside the insulating structure 110. The common source line structure 120 may be arranged across the cell region CELL, the connection region CON, and the outer pad region OPA. The common source line structure 120 may function as a common source line CSL (see FIGS. 1 and 3).

The common source line structure 120 may include a metal material, a semiconductor material, or a combination thereof. In some example embodiments, the common source line structure 120 may have a structure in which doped polysilicon 121, metal silicide 123, and metal layer 125 are sequentially stacked. Although the thickness of the doped polysilicon 121 in the drawing is illustrated greater than the thicknesses of the metal silicide 123 and the metal layer 125, this inventive concepts are not limited thereto. The characteristics of the common source line structure 120 will be described below, respectively, in the cell region CELL, the connection region CON, and the outer pad region OPA.

In the cell region CELL, the common source line structure 120 may be arranged to conformally surround the upper portion of the plurality of channel structures 140 located inside the insulating structure 110. That is, the common source line structure 120 may have an uneven shape. In some example embodiments, the vertical level of the bottom surface of the common source line structure 120 is substantially the same, and the vertical level of the bottom surface thereof may have a step. In other words, the common source line structure 120 has a square wave shape including a plurality of top surfaces, a plurality of bottom surfaces, a plurality of side surfaces connecting the plurality of top surfaces to a plurality of bottom surfaces such that the plurality of bottom surfaces are at a same vertical level and the plurality of top surfaces are at different vertical level.

In the connection region CON, the common source line structure 120 is arranged around the upper portion of the cell contact plug 160 located inside the insulating structure 110, but the upper portion of the cell contact plug 160 and the common source line structure 120 may be insulated by the insulating structure 110. In addition, the common source line structure 120 may be arranged to conformally surround the upper portion of a dummy contact plug 150 located inside the insulating structure 110. That is, the common source line structure 120 may have an uneven shape.

In the outer pad region OPA, the common source line structure 120 is arranged around the upper portions of the first and second contact structures 171 and 172 located inside the insulating structure 110, but the upper portions of the first and second contact structures 171 and 172 and the common source line structure 120 may be insulated by the insulating structure 110.

In the integrated circuit device 100 of this example embodiment, a first wiring line ML1 and a second wiring line ML2 may be arranged on a second surface 110S2 of the insulating structure 110. In some example embodiments, the first wiring line ML1 may be arranged in a line-and-space shape. Each of the first wiring lines ML1 is electrically connected to each other, but the first wiring line ML1 and the second wiring line ML2 may be spaced apart from each other and arranged not to be electrically connected. That is, the first wiring line ML1 and the second wiring line ML2 may be arranged to be spaced apart from each other at the same vertical level on the second surface 110S2 of the insulating structure 110.

When viewed from a plan view, the long axis direction of the first wiring line ML1 and the long axis direction of the second wiring line ML2 are orthogonal to each other, and the end portion of the first wiring line ML1 and the sidewall of the second wiring line ML2 may face each other but may be spaced apart. That is, the first wiring line ML1 may have a line shape extending in the first horizontal direction (X direction), and the second wiring line ML2 may have a line shape extending in the second horizontal direction (Y direction).

The first wiring line ML1 and the second wiring line ML2 may include, for example, a metal material such as aluminum (Al), copper (Cu), tungsten (W), silver (Ag), or gold (Au). In addition, the first wiring line ML1 and the second wiring line ML2 may be formed of the same material.

The first wiring line ML1 may be electrically connected to the common source line structure 120 through a first conductive via 191 in the cell region CELL. In addition, the first wiring line ML1 may be electrically connected to the first contact structure 171 through a first conductive via 191 in the outer pad region OPA. That is, the common source line structure 120 and the first contact structure 171 may be electrically connected by bypassing the common source line structure 120 such that the common source line structure 120, to which the common source line driver 39 (see FIG. 1) is connected, is electrically connected to the first contact structure 171 through the first wiring line ML1. In other words, the common source line structure 120 may be bypassed in the outer pad region OPA such that the first contact structure 171 is electrically connected to the first wiring line ML1 through the first conductive via 191. In this way, an ohmic junction may be formed between the first contact structure 171 and the first wiring line ML1. The common source line structure 120 is electrically connected to the first wiring line ML1 through another first conductive via 191 in the cell region CELL. In addition, the second wiring line ML2 may be electrically connected to the second contact structure 172 through a second conductive via 192 in the outer pad region OPA.

The first conductive via 191 may be formed through the insulating structure 110. The first conductive via 191 may directly contact the common source line structure 120 and the first wiring line ML1 to provide an electrical connection therebetween. The first conductive via 191 may have a tapered shape in which the width thereof gradually increases as the distance from the common source line structure 120 increases.

The second conductive via 192 may be formed through the insulating structure 110. The second conductive via 192 may directly contact the second contact structure 172 and the second wiring line ML2 to provide an electrical connection therebetween. The second conductive via 192 may have a tapered shape in which the width thereof gradually increases as the distance from the common source line structure 120 increases. In some example embodiments, the second conductive via 192 may be arranged only in the outer pad region OPA.

The first and second conductive vias 191 and 192 may include inner metal layers 191A and 192A such as copper (Cu), aluminum (Al), tungsten (W), silver (Ag), or gold (Au). In some example embodiments, the first and second conductive vias 191 and 192 may include barrier metal layers 191B and 192B such as tantalum (Ta), titanium (Ti), tantalum nitride (TaN), or titanium nitride (TiN) to block and prevent the inner metal layers 191A and 192A (e.g., elements in the inner metal layers 191A and 192A) from diffusing into the insulating structure 110.

The barrier metal layer 191B of the first conductive via 191 connected to the common source line structure 120 may be in direct contact with the metal layer 125 of the common source line structure 120, and the barrier metal layer 191B of the first conductive via 191 connected to the first contact structure 171 may be in direct contact with the conductive barrier layer 171B of the first contact structure 171. In addition, the barrier metal layer 192B of the second conductive via 192 connected to the second contact structure 172 may be in direct contact with the conductive barrier layer 172B of the second contact structure 172.

However, the sidewall of the first conductive via 191 connected to the first contact structure 171 may face the sidewall of the common source line structure 120, while the former may be insulated from the latter, and the sidewall of the second conductive via 192 connected to the second contact structure 172 may face the sidewall of the common source line structure 120, while the former may be insulated from the latter.

Here, the vertical length of the first conductive via 191 connecting the common source line structure 120 with the first wiring line ML1 in the cell region CELL may be greater than the vertical length of the first conductive via 191 connecting the first contact structure 171 with the first wiring line ML1 in the outer pad region OPA.

In order to meet the excellent performance and economic feasibility, it is desired to increase the degree of integration of an integrated circuit device 100. In particular, the degree of integration of memory devices is an important factor in determining the economic feasibility of a product. Accordingly, a vertical memory device having a three-dimensional structure is desired. Accordingly, in a bonding-type vertical memory device, when a common source line and a common source line driver are electrically connected with each other through direct bonding between a common source line and a contact structure, it is difficult to form a metal silicide between the common source line and the contact structure, and thus, there is a problem that ohmic junction could not be properly implemented.

According to some example embodiments of the inventive concepts, an ohmic contact between the first contact structure 171 and the first wiring line ML1 may be formed and thus the common source line structure 120, to which the common source line driver 39 (see FIG. 1) is connected, to the first contact structure 171 through the first wiring line ML1.

Thus, according to some example embodiments of the inventive concepts, electrical reliability of the integrated circuit device 100 increases while improving integration in a vertical memory device.

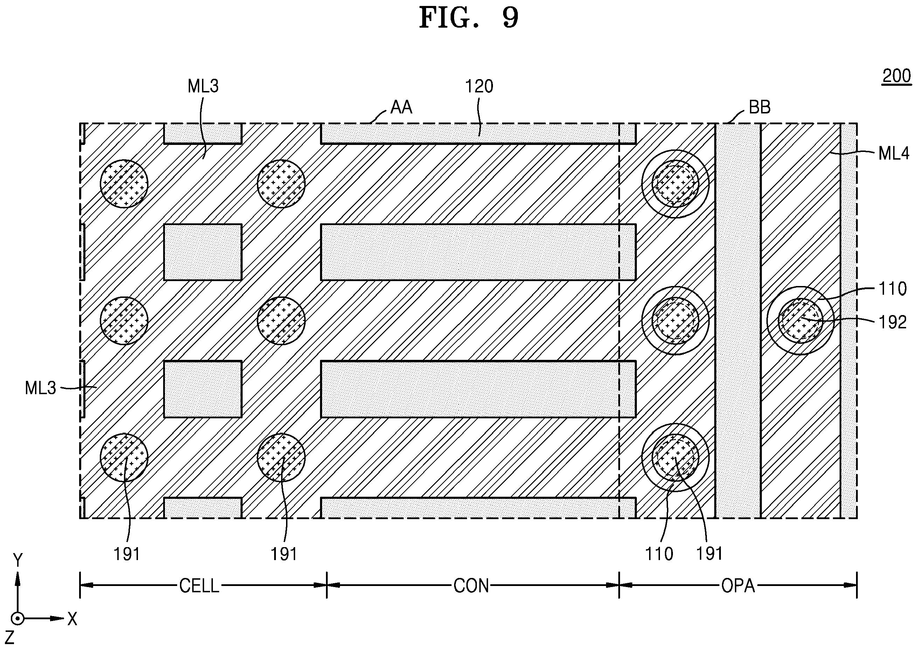

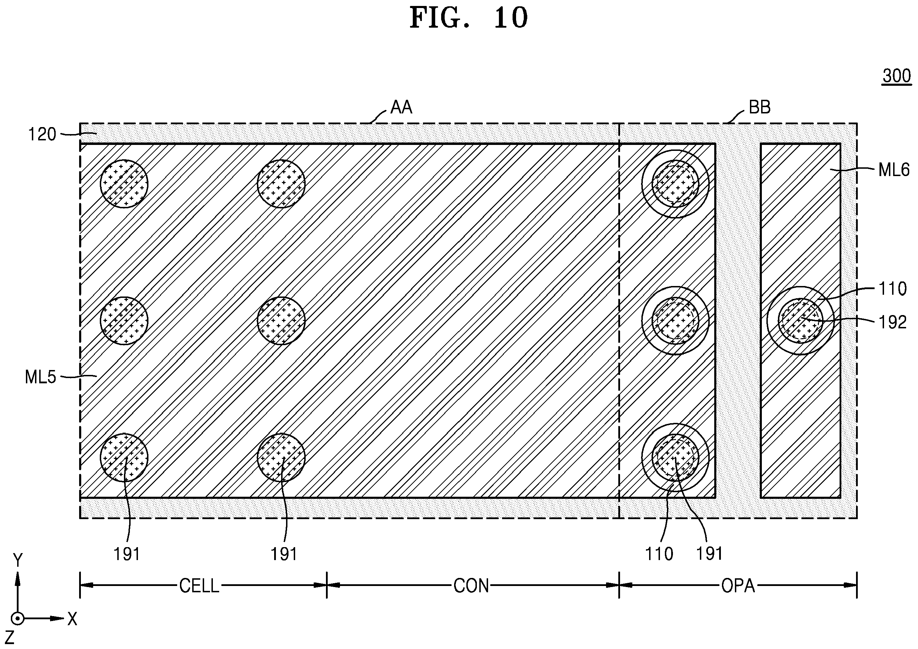

FIGS. 9 and 10 are plan views illustrating an integrated circuit device according to some example embodiments.

Most elements of the integrated circuit devices 200 and 300 described below and materials of the components are substantially the same as or similar to those described above with reference to FIGS. 4 to 8. Therefore, for convenience of description, a difference from the integrated circuit device 100 described above will be mainly described.

Referring to FIG. 9, when the integrated circuit device 200 is viewed from above in a vertical direction (Z direction), the plurality of first wiring lines ML3 may be formed in a mesh shape connected to each other.

In the integrated circuit device 200 of this example embodiment, the first wiring line ML3 and a second wiring line ML4 may be arranged on a second surface 110S2 of the insulating structure 110. The first wiring line ML3 may be arranged in a mesh shape crossing in the first horizontal direction (X direction) and the second horizontal direction (Y direction).

Accordingly, the first wiring lines ML3 may be electrically connected to each other, but the first wiring line ML3 and the second wiring line ML4 may be spaced apart from each other and may not be electrically connected. That is, the first wiring line ML3 and the second wiring line ML4 may be arranged to be spaced apart from each other at the same vertical level on the second surface 110S2 of the insulating structure 110. When viewed in a plan view, an end portion of the first wiring line ML3 and a side of the second wiring line ML4 may face each other and be spaced apart from each other.

The first wiring line ML3 and the second wiring line ML4 may include, for example, a metal material such as aluminum (Al), copper (Cu), tungsten (W), silver (Ag), or gold (Au). In addition, the first wiring line ML3 and the second wiring line ML4 may be formed of the same material.

Referring to FIG. 10, when the integrated circuit device 300 is viewed from above in the vertical direction (Z direction), the first wiring line ML5 may be formed in a plate shape.

In the integrated circuit device 300 of this example embodiment, the first wiring line ML5 and a second wiring line ML6 may be arranged on a second surface 110S2 of the insulating structure 110. The first wiring line ML5 may be arranged in a single plate shape. In addition, the second wiring line ML6 may be arranged in a single pad shape. The first wiring line ML5 and the second wiring line ML6 may be spaced apart from each other and may not be electrically connected to each other. That is, the first wiring line ML5 and the second wiring line ML6 may be spaced apart from each other at the same vertical level on the second surface 110S2 of the insulating structure 110. When viewed in a plan view, an end portion of the first wiring line ML5 and a sidewall of the second wiring line ML6 may face each other and be spaced apart from each other.

The first wiring line ML5 and the second wiring line ML6 may include, for example, a metal material such as aluminum (Al), copper (Cu), tungsten (W), silver (Ag), or gold (Au). In addition, the first wiring line ML5 and the second wiring line ML6 may be formed of the same material.

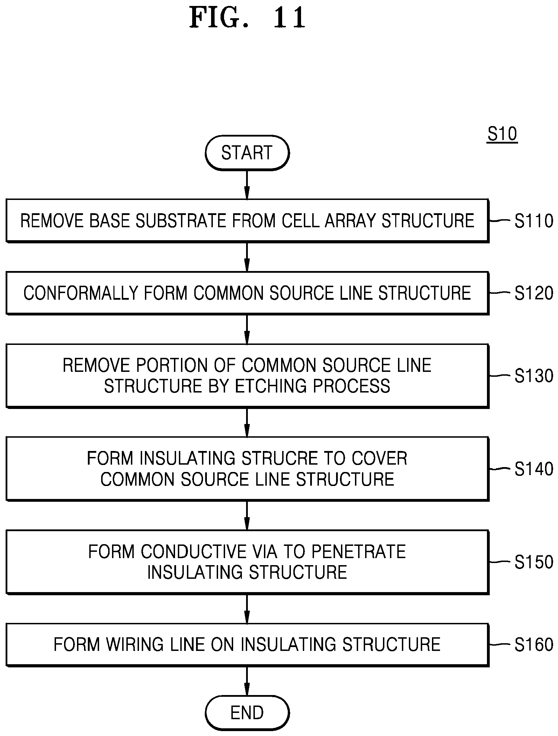

FIG. 11 is a flowchart illustrating a method of manufacturing an integrated circuit device according to an example embodiment.

Referring to FIG. 11, the method (S10) of manufacturing an integrated circuit device may include a process order of first to sixth operations (S 110 to S160).

When some example embodiments are implemented differently, a specific process sequence may be performed differently from the sequence described. For example, the two processes described continuously may be performed substantially simultaneously, or in the opposite sequence to the sequence described.

A method (S10) of manufacturing an integrated circuit device includes a first operation (S 110) of removing a base substrate from a cell array structure, a second operation (S 120) of conformally forming a common source line structure, a third operation (S130) of removing a portion of the common source line structure by an etching process, a fourth operation (S140) of forming an insulating structure to cover the common source line structure, a fifth operation (S150) of forming a conductive via to penetrate the insulating structure, and a sixth operation (S160) of forming a wiring line on the insulating structure.

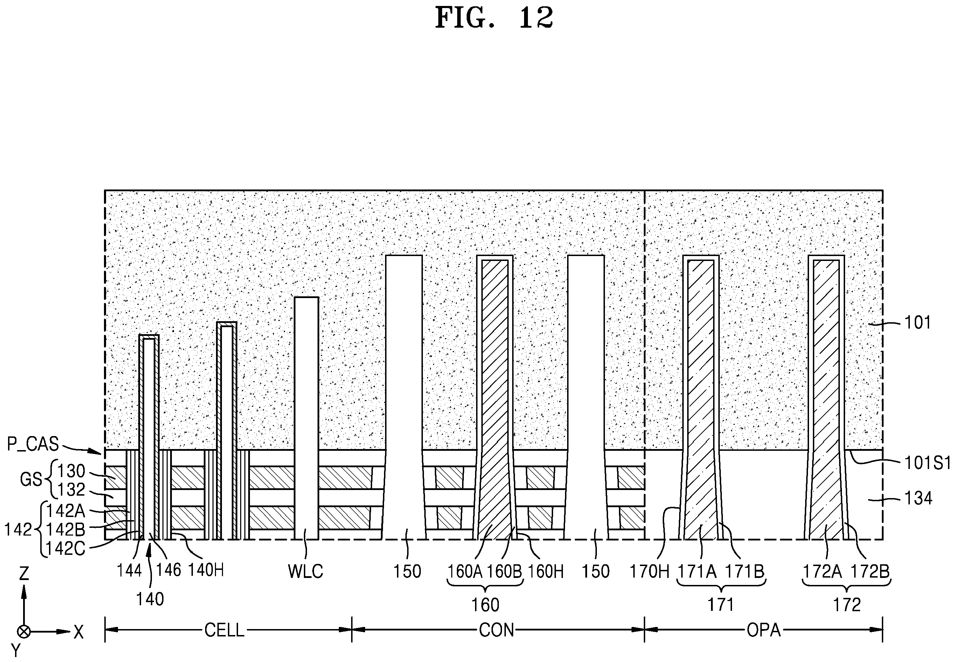

Technical features of the first to fifth operations S110 to S160 will be described in detail with reference to FIGS. 12 to 19 to be described later.

FIGS. 12 to 19 are cross-sectional views showing, in accordance with a process sequence, a method of manufacturing an integrated circuit device, according to an example embodiment.

For convenience of description, a method of manufacturing an integrated circuit device for a region corresponding to FIG. 5 is described, but a person skilled in the art will easily understand a method of manufacturing other portions of the integrated circuit device.

Referring to FIG. 12, a preliminary cell array structure P_CAS which is a portion of the cell array structure CAS (see FIG. 4) may be formed.

The preliminary cell array structure P_CAS may include a base substrate 101, a gate stack GS on the first surface 101 S1 of the base substrate 101, and a cover insulation layer 134 covering the gate stack GS.

In the cell region CELL, a plurality of channel structures 140 may penetrate the gate stack GS and extend in a vertical direction (Z direction). The plurality of channel structures 140 may be arranged at desired (or alternatively, predetermined) intervals in the first horizontal direction (X direction) and the second horizontal direction (Y direction). In the drawings, the upper portions of the plurality of channel structures 140 may be formed to extend to the inside of the base substrate 101.

In the cell region CELL and/or the connection region CON, a word line cut WLC may penetrate the gate stack GS and extend in a vertical direction (Z direction). In the drawing, the upper portion of the word line cut WLC may be formed to extend to the inside of the base substrate 101.

In the connection region CON, the cell contact plug 160 may pass through the plurality of gate electrode layers 130 and may extend in the vertical direction (Z direction). As illustrated in FIG. 12, the upper portion of the cell contact plug 160 may be formed to extend to the inside of the base substrate 101. The dummy contact plug 150 may be arranged around the cell contact plug 160. As illustrated in FIG. 12, the upper portion of the dummy contact plug 150 may be formed to extend to the inside of the base substrate 101.

In the outer pad region OPA, the first and second contact structures 171 and 172 may pass through the cover insulating layer 134 and extend in a vertical direction (Z direction). As illustrated in FIG. 12, the upper portions of the first and second contact structures 171 and 172 may be formed to extend to the inside of the base substrate 101.

Here, due to differences in manufacturing processes, at least one of the top level of the plurality of channel structures 140, the top level of the word line cut WLC, the top level of the cell contact plug 160, the top level of the dummy contact plug 150, and the top levels of the first and second contact structures 171 and 172 may be differently formed from the others.

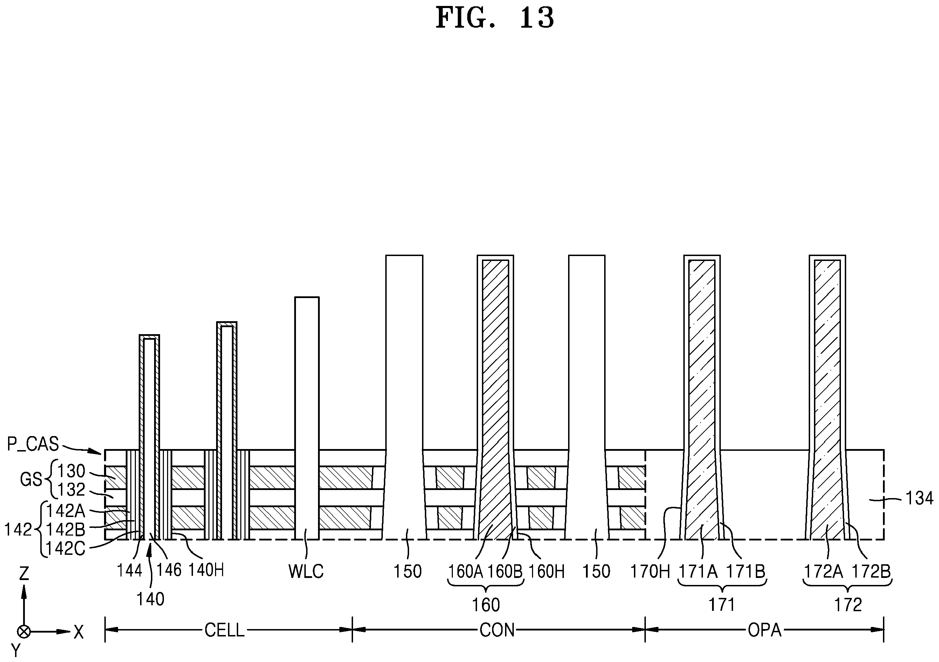

Referring to FIG. 13, the base substrate 101 (see FIG. 12) may be removed from the preliminary cell array structure P_CAS to expose the top surface of the cover insulating layer 134.

In some example embodiments, a grinding process, a wet etching process, a dry etching process, or a combination thereof may be used to remove the base substrate 101 (see FIG. 12).

By removing the base substrate 101 (see FIG. 12), upper portions of the plurality of channel structures 140, an upper portion of the word line cut, an upper portion of the cell contact plug 160, an upper portion of the dummy contact plug 150, and upper portions of the first and second contact structures 171 and 172 may be exposed to the outside.

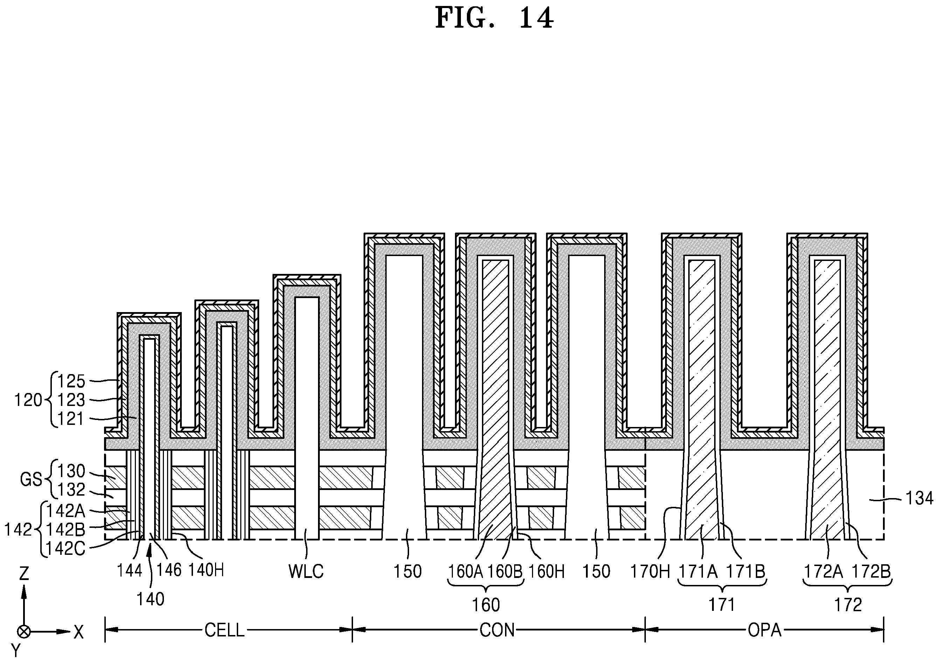

Referring to FIG. 14, a common source line structure 120 may be formed to conformally cover the upper portions of the plurality of channel structures 140, the upper portions of the word line cut WLC, the upper portion of a cell contact plug 160, the upper portion of the dummy contact plug 150, and the upper portions of the first and second contact structures 171 and 172.

The common source line structure 120 may include a metal material, a semiconductor material, or a combination thereof. In some example embodiments, the common source line structure 120 may have a structure in which doped polysilicon 121, metal silicide 123, and metal layer 125 are sequentially stacked.

In some example embodiments, to conformally form the common source line structure 120, for example, the formation process of the common source line structure 120 may use a Chemical Vapor Deposition (CVD) process or an atomic layer deposition (ALD) process.

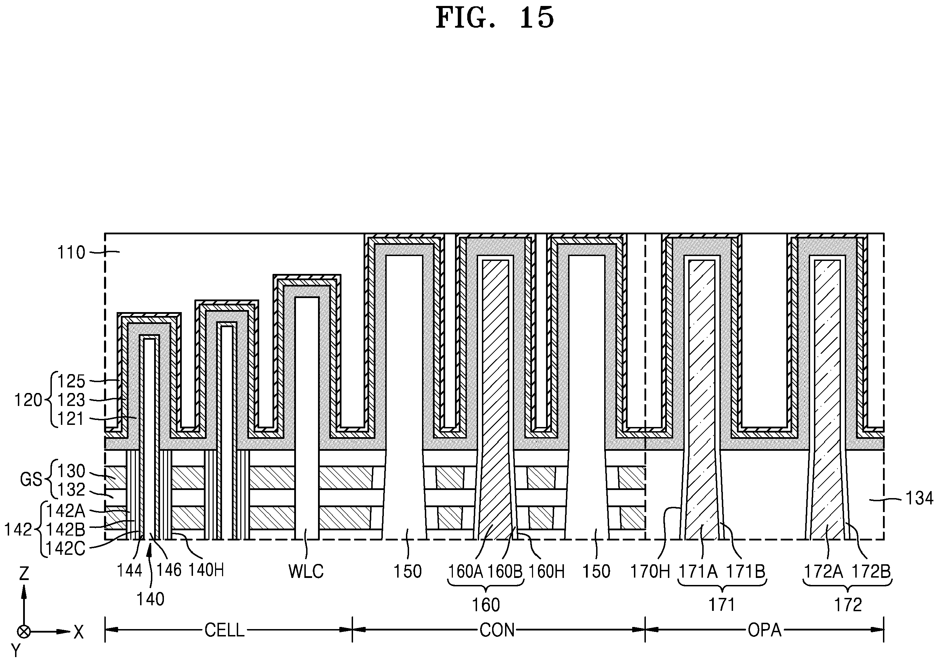

Referring to FIG. 15, an insulating structure 110 may be primarily formed to surround the common source line structure 120.

The insulating structure 110 may be formed to fill all curved shapes of the common source line structure 120. However, the insulating structure 110 may be formed so as not to cover the uppermost surface of the common source line structure 120. That is, the uppermost surface of the insulating structure 110 and the uppermost surface of the common source line structure 120 may have the same vertical level.

The insulating structure 110 may include, for example, silicon oxide, silicon nitride, a low-k material, or a combination thereof. The low-k material is a material with a lower dielectric constant than silicon oxide, and may include, for example, phosphosilicate glass (PSG), borophosphosilicate glass (BPSG), fluorosilicate glass (FSG), organosilicate glass (OSG), spin-non-glass (SOG), or a combination thereof.

In some example embodiments, to conformally form the insulating structure 110, for example, the formation process of the insulating structure 110 may use a CVD process or an ALD process.

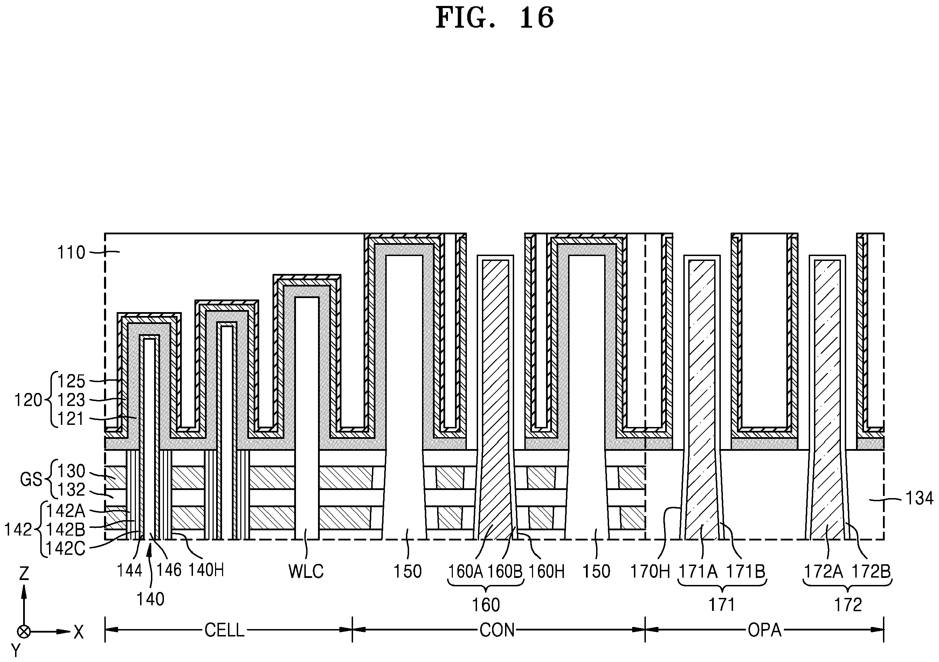

Referring to FIG. 16, a portion of the common source line structure 120 covering the upper portion of the cell contact plug 160 and the upper portions of the first and second contact structures 171 and 172 may be removed by an etching process.

The etching process may selectively remove a portion of the common source line structure 120 from the desired region by using a photomask (not shown) formed by a photographic process as an etching mask.

Meanwhile, during the etching process, the upper portion of the cell contact plug 160 and the upper portions of the first and second contact structures 171 and 172 are not etched and may be maintained so as not to collapse or break. In other words, the etching process is carried out to reduce or minimize etching damage on the upper portion of the cell contact plug 160 and the upper portions of the first and second contact structures 171 and 172 using the etching selection ratio.

Accordingly, the upper portion of the cell contact plug 160 and the upper portions of the first and second contact structures 171 and 172 are exposed to the outside and may be formed in a pillar shape extending in the vertical direction (Z direction).

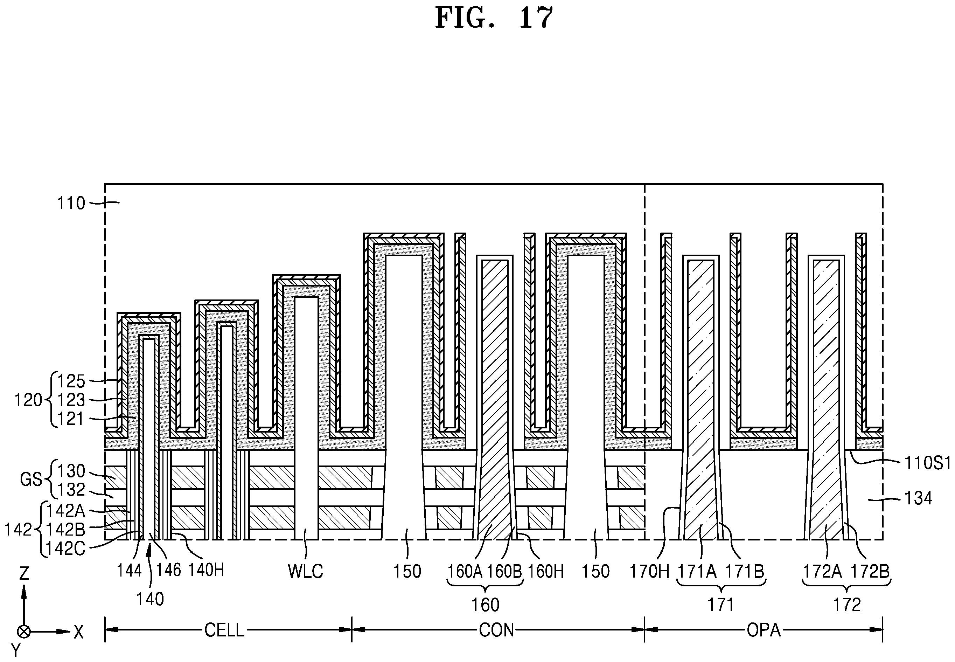

Referring to FIG. 17, an insulating structure 110 may be secondarily formed to surround the upper portion of the cell contact plug 160 and the upper portions of the first and second contact structures 171 and 172.

The insulating structure 110 may fill both curved shapes at the upper portion of the cell contact plug 160 and at the upper portions of the first and second contact structures 171 and 172. In addition, the insulating structure 110 may be thick enough to cover all the uppermost surfaces of the common source line structure 120. That is, the level of the uppermost surface of the insulating structure 110 may have a higher vertical level than the level of the uppermost surface of the common source line structure 120.

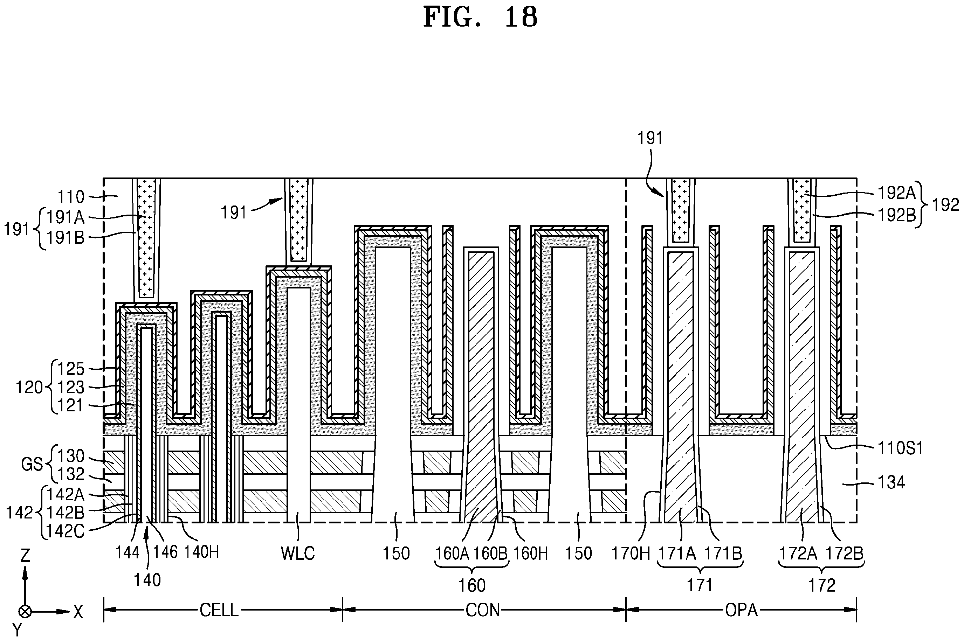

Referring to FIG. 18, the first and second conductive vias 191 and 192 penetrating the insulating structure 110 may be formed.

A first one of the first conductive vias 191 may penetrate the insulating structure 110 to directly contact the common source line structure 120. In addition, a second one of the first conductive vias 191 may penetrate the insulating structure 110 to directly contact the first contact structure 171. The first one of the first conductive vias 191 may have a tapered shape in which the width thereof gradually increases as the distance from the common source line structure 120 increases. The second one of the first conductive vias 191 may have a tapered shape in which the width thereof gradually increases as the distance from the first contact structure 171 increases.

The second conductive via 192 may penetrate the insulating structure 110 to directly contact the second contact structure 172. The second conductive via 192 may have a tapered shape in which the width thereof gradually increases as the distance from the common source line structure 120 increases.

The first and second conductive vias 191 and 192 may include inner metal layers 191A and 192A and barrier metal layers 191B and 192B to block or prevent the inner metal layers 191A and 192A (e.g., elements in the inner metal layers 191A and 192A) from diffusing into the insulating structure 110.

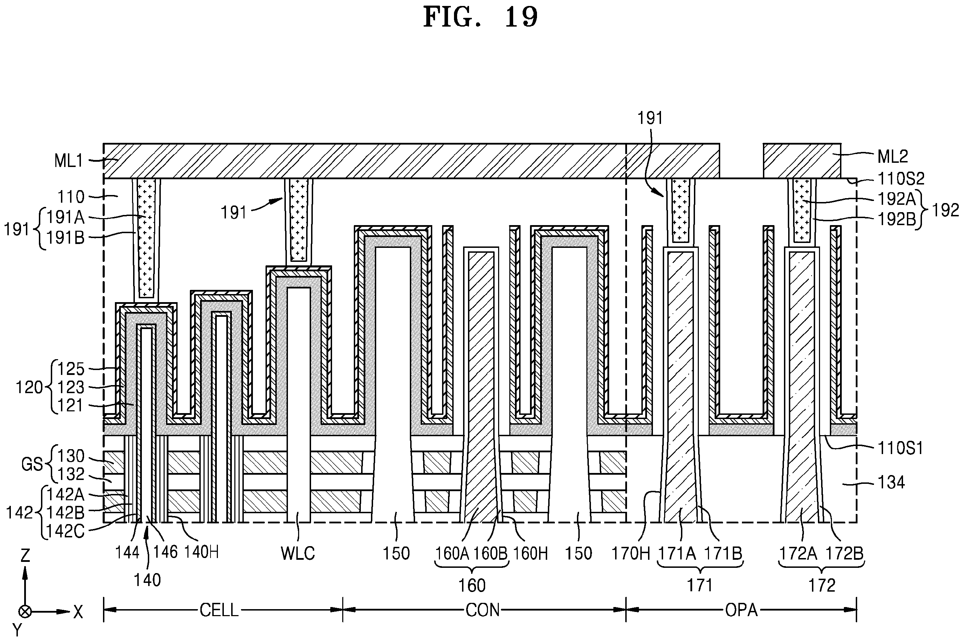

Referring to FIG. 19, the first wiring line ML1 and the second wiring line ML2 may be formed on the second surface 110S2 of the insulating structure 110.

The first wiring line ML1 and the second wiring line ML2 may be spaced apart from each other and formed so as not to be electrically connected to each other. That is, the first wiring line ML1 and the second wiring line ML2 may be formed to be spaced apart from each other at the same vertical level on the second surface 110S2 of the insulating structure 110.

In some example embodiments, each of the first wiring line ML1 and the second wiring line ML2 may include a metal material such as aluminum (Al), copper (Cu), tungsten (W), silver (Ag), or gold (Au). In addition, because the first wiring line ML1 and the second wiring line ML2 are formed in the same process, the first wiring line ML1 and the second wiring line ML2may be made of the same material.

The first wiring line ML1 may be electrically connected to the common source line structure 120 through the first conductive via 191 and may be electrically connected to the first contact structure 171 through the first conductive via 191. In addition, the second wiring line ML2 may be electrically connected to the second contact structure 172 through the second conductive via 192.

Referring back to FIG. 5, an insulating layer may surround the first wiring line ML1 and the second wiring line ML2, thereby completing the integrated circuit device 100 according to an example embodiment.

FIG. 20 is a diagram illustrating an electronic system including an integrated circuit device according to an example embodiment.

Referring to FIG. 20, the electronic system 1000 may include an integrated circuit device 1100 and a controller 1200 electrically connected to the integrated circuit device 1100.

The electronic system 1000 may be a storage device including the integrated circuit device 1100 or an electronic device including the storage device. For example, the electronic system 1000 may be a solid state drive (SSD) device, a Universal Serial Bus (USB), a computing system, a medical device, or a communication device including at least one integrated circuit device 1100.

The integrated circuit device 1100 may be a nonvolatile vertical memory device. For example, the integrated circuit device 1100 may be a NAND flash memory device including at least one of the integrated circuit devices 100, 200, and 300 described above with reference to FIGS. 4 to 10. The integrated circuit device 1100 may include a first structure 1100F and a second structure 1100S on the first structure 1100F. In some example embodiments, the first structure 1100F may be arranged next to the second structure 1100S. The first structure 1100F may be a peripheral circuit structure including a decoder circuit 1110, a page buffer 1120, and a logic circuit 1130. The second structure 1100S may be a memory cell structure including a bit line BL, a common source line CSL, a plurality of word lines WL, first and second gate upper lines (UL1 and UL2, first and second gate lower lines LL1 and LL2, and a plurality of memory cell strings CSTR between the bit line BL, and the common source line CSL.

In the second structure 1100S, the plurality of memory cell strings CSTR may each include lower transistors LT1 and LT2 adjacent to the common source line CSL, upper transistors UT1 and UT2 adjacent to the bit line BL, and a plurality of cell transistors MCT arranged between the lower transistors LT1 and LT1 and the upper transistors UT1 and UT2. The number of the lower transistors LT1 and LT2 and the number of the upper transistors UT1 and UT2 may be variously modified according to example embodiments.

In some example embodiments, the upper transistors UT1 and UT2 may include string selection transistors, and the lower transistors LT1 and LT2 may include ground selection transistors. A plurality of gate lower lines LL1 and LL2 may be gate electrodes of the lower transistors LT1 and LT2, respectively. The word line WL may be a gate electrode of the memory cell transistor MCT, and the gate upper lines UL1 and UL2 may be gate electrodes of the upper transistors UT1 and UT2.

The common source line CSL, the plurality of gate lower lines LL1 and LL2, the plurality of word lines WL, and the plurality of gate upper lines UL1 and UL2 may be electrically connected to a decoder circuit 1110 through a plurality of first connection lines 1115 extending from the first structure 1100F to the second structure 1100S. The plurality of bit lines BL may be electrically connected to a page buffer 1120 through a plurality of second connection lines 1125 extending from the first structure 1100F to the second structure 1100S.

In the first structure 1100F, the decoder circuit 1110 and the page buffer 1120 may perform a control operation on at least one of the plurality of memory cell transistors MCT. The decoder circuit 1110 and the page buffer 1120 may be controlled by the logic circuit 1130.

The integrated circuit device 1100 may communicate with the controller 1200 through an input/output pad 1101 electrically connected to the logic circuit 1130. The input/output pad 1101 may be electrically connected to a logic circuit 1130 through an input/output connection wiring 1135 extending from the first structure 1100F to the second structure 1100S.

The controller 1200 may include a processor 1210, a NAND controller 1220, and a host interface 1230. In some example embodiments, the electronic system 1000 may include a plurality of integrated circuit devices 1100, in which case the controller 1200 may control the plurality of integrated circuit devices 1100.

The processor 1210 may control overall operations of the electronic system 1000 including the controller 1200. The processor 1210 may operate according to a desired (or alternatively, predetermined) firmware, and may access the integrated circuit device 1100 by controlling a NAND controller 1220. The NAND controller 1220 may include a NAND interface 1221 that processes communication with the integrated circuit device 1100. Control commands for controlling the integrated circuit device 1100, data to be recorded in the plurality of memory cell transistors MCT of the integrated circuit device 1100, and data to be read from the plurality of memory cell transistors MCT of the integrated circuit device 1100 may be transmitted through a NAND interface 1221. The host interface 1230 may provide a communication function between the electronic system 1000 and an external host. When receiving a control command from an external host through the host interface 1230, the processor 1210 may control the integrated circuit device 1100 in response to the control command.

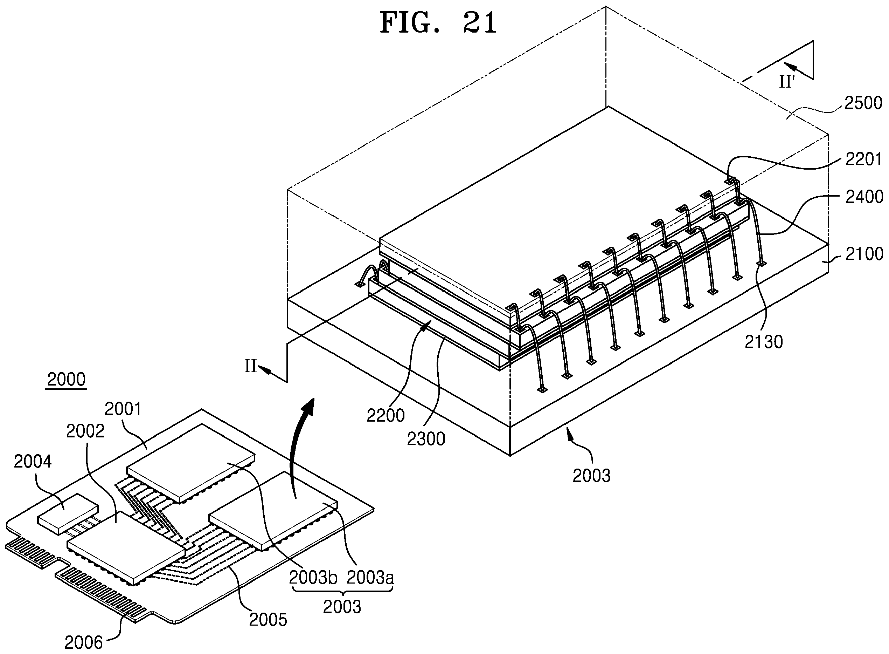

FIG. 21 is a perspective diagram illustrating an electronic system including an integrated circuit device according to an example embodiment.

Referring to FIG. 21, the electronic system 2000 may include a main substrate 2001, and a controller 2002, one or more semiconductor packages 2003, and a DRAM 2004, which are mounted in the main substrate 2001. The semiconductor packages 2003 and the DRAM 2004 may be connected to the controller 2002 by a plurality of wiring patterns 2005 formed in the main substrate 2001.

The main substrate 2001 may include a connector 2006 including a plurality of pins coupled to the external host. The number and arrangement of the plurality of pins in a connector 2006 may vary depending on the communication interface between the electronic system 2000 and the external host. In some configurations, the electronic system 2000 may communicate with an external host according to any one of the interfaces such as universal serial bus (USB), Peripheral Component Interconnect Express (PCI-Express), Serial Advanced Technology Attachment (SATA), and M-Phy for Universal Flash Storage (UFS). In some configurations, the electronic system 2000 may be operated by power supplied from the external host through the connector 2006. The electronic system 2000 may further include a Power Management Integrated Circuit (PMIC) that distributes power supplied from the external host to the controller 2002 and the semiconductor package 2003.

The controller 2002 may record data in the semiconductor package 2003, read data from the semiconductor package 2003, and improve the operating speed of the electronic system 2000.

The DRAM 2004 may be a buffer memory for alleviating a speed difference between the semiconductor package 2003 which is a data storage space and the external host. The DRAM 2004 included in the electronic system 2000 may also operate as a kind of cache memory, and may provide space for temporarily storing data in a control operation for the semiconductor package 2003. When the electronic system 2000 includes the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. Each of the first and second semiconductor packages 2003a and 2003b may be a semiconductor package including a plurality of semiconductor chips 2200. Each of the first and second semiconductor packages 2003a and 2003b may include a package substrate 2100, the plurality of semiconductor chips 2200 on the package substrate 2100, an adhesive layer 2300 arranged on the lower surface of each of the plurality of semiconductor chips 2200, a connection structure 2400 electrically connecting the plurality of semiconductor chips 2200 with the package substrate 2100, and a molding layer 2500 covering the plurality of semiconductor chips 2200 and the connection structure 2400 on the package substrate 2100.

The package substrate 2100 may be a printed circuit board including a plurality of package upper pads 2130. Each of the plurality of semiconductor chips 2200 may include an input/output pad 2201. The input/output pad 2201 may correspond to the input/output pad 1101 (see FIG. 20). Each of the plurality of semiconductor chips 2200 may include at least one of the integrated circuit devices 100, 200, and 300 described above with reference to FIGS. 4 to 10.

In some example embodiments, the connection structure 2400 may be a bonding wire electrically connecting the input/output pad 2201 with each of a plurality of package upper pads 2130. Therefore, in the first and second semiconductor packages 2003a and 2003b, the plurality of semiconductor chips 2200 may be electrically connected to each other in a bonding wire manner, and may be electrically connected to the package upper pads 2130 on the package substrate 2100. In some example embodiments, in the first and second semiconductor packages 2003a and 2003b, the plurality of semiconductor chips 2200 may be electrically connected to each other by a connection structure including a TSV instead of a bonding wire-type connection structure 2400.

In some example embodiments, the controller 2002 and the plurality of semiconductor chips 2200 may be included in one package. In some example embodiments, the controller 2002 and the plurality of semiconductor chips 2200 may be mounted on a separate interposer substrate different from the main substrate 2001, and the controller 2002 and the plurality of semiconductor chips 2200 may be connected to each other by wiring formed on the interposer substrate.

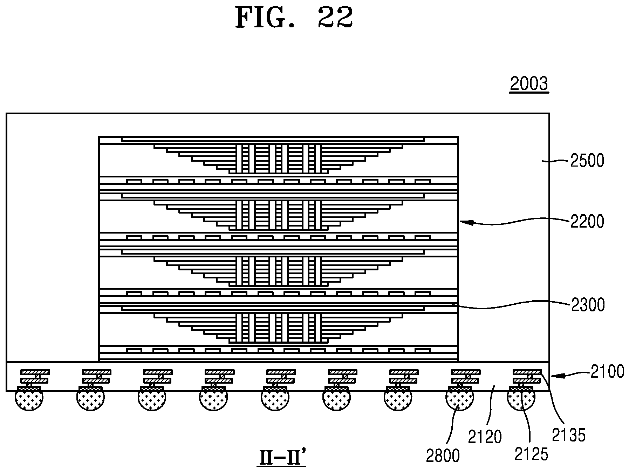

FIG. 22 is a cross-sectional view illustrating a semiconductor package including an integrated circuit device according to an example embodiment.

Referring to FIG. 22, in the semiconductor package 2003, the package substrate 2100 may be a printed circuit board.

The package substrate 2100 may include a body 2120, a package upper pad 2130 (see FIG. 21) arranged on the top surface of the body 2120, a plurality of package lower pads 2125 arranged on or exposed through the bottom surface of the body 2120, and a plurality of internal wirings 2135 electrically connecting the package upper pads 2130 (see FIG. 21) with the package lower pads 2125 inside the body 2120.

The plurality of package lower pads 2125 may be connected to a plurality of wiring patterns 2005 on the main substrate 2001 (see FIG. 21) through a plurality of conductive bumps 2800. Each of the plurality of semiconductor chips 2200 may include at least one of the integrated circuit devices 100, 200, and 300 described above with reference to FIGS. 4 to 10.

Any functional blocks shown in the figures and described above may be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

While the inventive concepts have been particularly shown and described with reference to some example embodiments thereof, it will be understood that various changes in form and details may be made therein without departing from the scope of the following claims.

## Claims

1. An integrated circuit device comprising:
a peripheral circuit structure; and
a cell array structure,
wherein the peripheral circuit structure includes
a circuit board,
a peripheral circuit on the circuit board,
a first insulating layer covering the circuit board and the peripheral circuit, and
first bonding pads on the first insulating layer and electrically connected to the peripheral circuit, and
wherein the cell array structure includes
an insulating structure having a first surface and a second surface, the first surface facing the circuit board, the second surface being opposite to the first surface,
a plurality of gate electrode layers spaced apart from each other in a vertical direction on the first surface of the insulating structure, and stacked in a step form,
a plurality of channel structures passing through the plurality of gate electrode layers,
a cell contact plug passing through at least a portion of the plurality of gate electrode layers,
a first contact structure and a second contact structure laterally spaced apart from the plurality of gate electrode layers,
a common source line structure conformally surrounding an upper portion of the plurality of channel structures and being inside the insulating structure,
a first wiring line and a second wiring line spaced apart from each other on the second surface of the insulating structure,
first conductive vias passing through the insulating structure, connecting the common source line structure with the first wiring line, and connecting the first contact structure with the first wiring line,
a second conductive via passing through the insulating structure and connecting the second contact structure with the second wiring line, and
second bonding pads connected to a lower portion of the plurality of channel structures, a lower portion of the cell contact plug, a lower portion of the first contact structure, and a lower portion of the second contact structure, and bonded to the first bonding pads.

2. The integrated circuit device of claim 1, wherein the common source line structure has a square wave shape including a plurality of top surfaces, a plurality of bottom surfaces, a plurality of side surfaces connecting the plurality of top surfaces to the plurality of bottom surfaces such that the plurality of bottom surfaces are at a same vertical level and the plurality of top surfaces are at different vertical levels.

3. The integrated circuit device of claim 2, wherein the common source line structure has a structure in which doped polysilicon, a metal silicide, and a metal layer are sequentially stacked.

4. The integrated circuit device of claim 3, wherein
each of the first conductive vias includes a barrier metal layer and an inner metal layer, the first conductive via includes a first set of the first conductive vias that are connected to the common source line structure and a second set of the first conductive vias that are connected to the first contact structure,
the barrier metal layer in each of the first set of the first conductive vias is in direct contact with the metal layer of the common source line structure, and
the barrier metal layer of each of the second set of the first conductive vias is in direct contact with the first contact structure.

5. The integrated circuit device of any preceding claim, wherein a vertical length of the first conductive vias connecting the common source line structure with the first wiring line is greater than a vertical length of the first conductive vias connecting the first contact structure with the first wiring line.

6. The integrated circuit device of any preceding claim, wherein
the common source line structure is around an upper portion of each of the first and second contact structures, the upper portion being inside the insulating structure, and
the insulating structure is interposed between the upper portions of the first and second contact structures and the common source line structure.

7. The integrated circuit device of claim 6, wherein
a sidewall of each of the first conductive vias connected to the first contact structure faces a corresponding sidewall of the common source line structure and is insulated from the corresponding sidewall of the common source line structure, and
a sidewall of the second conductive via connected to the second contact structure faces a corresponding sidewall of the common source line structure and is insulated from the corresponding sidewall of the common source line structure.

8. The integrated circuit device of claim 7, wherein
the common source line structure and the first contact structure are electrically connected to each other through the first wiring line, and
the common source line structure and the second contact structure are not electrically connected to each other.

9. The integrated circuit device of any of claims 1 to 5, wherein
the common source line structure is around an upper portion of the cell contact plug that is inside the insulating structure, and
the insulating structure is interposed between the upper portion of the cell contact plug and the common source line structure.

10. The integrated circuit device of any preceding claim, wherein, when viewed in a plan view, a long axis direction of the first wiring line and a long axis direction of the second wiring line are orthogonal to each other, and an end of the first wiring line and a side of the second wiring line face each other and are spaced apart from each other.

11. An integrated circuit device comprising:
an insulating structure having a memory cell region, a connection region surrounding the memory cell region, and an outer pad region surrounding the connection region;
a gate stack including a plurality of gate electrode layers and a plurality of mold insulating layers, the plurality of gate electrode layers and the plurality of mold insulating layers extending in a horizontal direction and alternately stacked in a vertical direction on a bottom surface of the insulating structure, and the gate stack having a staircase structure in the connection region;
a plurality of channel structures passing through the gate stack in the vertical direction and extending to an inside of the insulating structure in the memory cell region;
a word line cut passing through the gate stack in the vertical direction in the memory cell region and the connection region, the word line cut extending to the inside of the insulating structure;
a first contact structure and a second contact structure laterally spaced apart from the gate stack, in the outer pad region, the first contact structure and the second contact structure extending to the inside of the insulating structure;
a common source line structure conformally surrounding an upper portion of the plurality of channel structures and an upper portion of the word line cut, the upper portion of the plurality of channel structures and the upper portion of the word line cut being inside the insulating structure;
a first wiring line extending along the memory cell region, the connection region, and the outer pad region on a top surface of the insulating structure;
a second wiring line in the outer pad region and spaced apart from the first wiring line;
first conductive vias passing through the insulating structure, connecting the common source line structure with the first wiring line in the memory cell region, and connecting the first contact structure with the first wiring line in the outer pad region; and
a second conductive via passing through the insulating structure and connecting the second contact structure with the second wiring line, in the outer pad region.

12. The integrated circuit device of claim 11, wherein
the common source line structure has a square wave shape including a plurality of top surfaces, a plurality of bottom surfaces, a plurality of side surfaces connecting the plurality of top surfaces to the plurality of bottom surfaces such that the plurality of bottom surfaces are at a same vertical level and the plurality of top surfaces are at different vertical levels, and
the common source line structure has a structure in which doped polysilicon, tungsten silicide, and tungsten are sequentially stacked.

13. The integrated circuit device of claim 11 or 12, wherein
a vertical length of a first set of the first conductive vias connecting the common source line structure with the first wiring line is greater than a vertical length of a second set of the first conductive vias connecting the first contact structure with the first wiring line, and
a vertical length of the second set of the first conductive vias connecting the first contact structure with the first wiring line is same as a vertical length of the second conductive via.

14. The integrated circuit device of any of claims 11 to 13, wherein the first wiring line and the second wiring line include aluminum, and the first conductive vias and the second conductive via include tungsten.

15. The integrated circuit device of any of claims 11 to 14, wherein, when viewed in a plan view, an end of the first wiring line and a side of the second wiring line are spaced apart from each other while facing each other.
